# EUROPEAN PATENT SPECIFICATION

(11) **EP 3 982 135 B1**
(45) Date of publication and mention of the grant of the patent: **11.09.2024**
(21) Application number: 20201342.1
(22) Date of filing: 12.10.2020
(51) Int. Cl.: G01R 31/28

(54) **TEST TARGET DEFECT IDENTIFICATION AND EVALUATION FOR ASSESSING QUALITY OF COMPONENT CARRIER STRUCTURE**
PRÜFZIELFEHLERERKENNUNG UND -AUSWERTUNG ZUR BEURTEILUNG DER QUALITÄT EINER KOMPONENTENTRÄGERSTRUKTUR
IDENTIFICATION DE DÉFAUTS DE CIBLE DE TEST ET ÉVALUATION D'ÉVALUATION DE LA QUALITÉ D'UNE STRUCTURE DE SUPPORT DE COMPOSANTS

(43) Date of publication of application: 13.04.2022
(73) Proprietor: AT & S Austria Technologie & Systemtechnik Aktiengesellschaft, 8700 Leoben-Hinterberg (AT)
(72) Inventor: Schutting, Günter, 8605 Kapfenberg (AT); Gruber, Irene, 8793 Trofaiach (AT); Spitzer, Robert, 8680 Mürzzuschlag (AT); Pacher, Gernot, 8750 Judenburg (AT); Schwaiger, Jürgen, 8621 Thörl (AT); Titjung, Florian, 8605 Kapfenberg (AT)
(74) Representative: Dilg, Haeusler, Schindelmann Patentanwaltsgesellschaft mbH

(56) References cited:
- US-A- 4 592 138
- US-A- 4 648 212
- US-A- 4 858 479
- US-A- 5 006 295
- US-A1- 2015 212 114
- US-A1- 2020 319 230

## Description

The invention relates to an apparatus for and a method of testing quality of a component carrier structure, a computer-readable medium, and a program element.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically reliable so as to be operable even under harsh conditions.

Cross-sectioning is a technique used to characterize materials, perform a failure analysis and expose an internal structure of a component carrier such as a printed circuit board (PCB). Cross-sectioning may involve mounting a target segment of the PCB in a potting material to obtain support and protect the PCB in a subsequent grinding and polishing process. The mounted PCB is carefully ground and then polished using progressively finer media to reach a target examination plane of interest. The PCB prepared in this way may then be inspected by a user, for instance under an optical microscope or a scanning electron microscope (SEM). Flat grinding is another technique for exposing an interior of a component carrier for inspection by a user.

Preparing and testing cross-sections of component carriers, flat ground component carriers, and related physical bodies is conventionally carried out manually by engineers. This holds for different types of microsections such as cross-sections and flat sections. However, this involves a high effort and a limited precision in terms of quality testing and may be critical concerning tough requirements regarding throughput on an industrial scale.

US4,648,212 and US4,858,479 disclose operations on printed circuit boards.

It is an object of the invention to assess quality of component carrier structures with high reliability, high throughput and reasonable effort.

In order to achieve the object defined above, an apparatus for and a method of testing quality of a component carrier structure, a computer-readable medium, and a program element according to the independent claims are provided.

According to the invention, an apparatus for testing quality of a component carrier structure is provided, wherein the apparatus comprises a material removal unit configured for removing material of the component carrier structure for exposing a plane in an interior of the component carrier structure, a detection unit configured for detecting component carrier structure specific data (in particular image data) of the exposed plane of the component carrier structure, a determining unit configured for determining at least one pre-defined test target of the component carrier structure at the exposed plane based on the component carrier structure specific data, and an evaluation unit configured for identifying and evaluating at least one defect of the at least one determined test target for assessing quality of the component carrier structure (in particular, it may be possible to measure and evaluate one or more geometric features against a pre-defined specification).

According to the invention, a method of testing quality of a component carrier structure is provided, wherein the method comprises removing material of the component carrier structure for exposing a plane in an interior of the component carrier structure, detecting component carrier structure specific data (in particular image data) of the exposed plane of the component carrier structure, determining at least one pre-defined test target of the component carrier structure at the exposed plane based on the component carrier structure specific data, and identifying and evaluating at least one defect of the at least one determined test target for assessing quality of the component carrier structure.

According to the invention, a program element (for instance a software routine, in source code or in executable code) is provided, which, when being executed by a processor (such as a microprocessor or a CPU), causes an apparatus having the above mentioned features to execute the steps of a method having the above mentioned features.

According to the invention, a computer-readable medium (for instance a CD, a DVD, a USB stick, an SD card, a floppy disk or a hard disk, or any other (in particular also smaller) storage medium) is provided, in which a computer program is stored which, when being executed by a processor (such as a microprocessor or a CPU), causes an apparatus having the above mentioned features to execute the steps of a method having the above mentioned features.

Data processing which may be performed according to embodiments of the invention can be realized by a computer program, that is by software, or by using one or more special electronic optimization circuits, that is in hardware, or in hybrid form, that is by means of software components and hardware components.

In the context of the present application, the term "component carrier" may particularly denote any support structure which is capable of accommodating one or more components thereon and/or therein for providing mechanical support and/or electrical connectivity and/or optical connectivity and/or thermal connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "component carrier structure" may particularly denote a thin sheet handled and processed during and/or after manufacturing component carriers, for instance a panel, an array or a component carrier itself. Thus, a component carrier structure may particularly denote a panel comprising multiple connected preforms of component carriers, an array (such as a quarter panel) comprising multiple connected preforms of component carriers, a preform of a component carrier (i.e. a component carrier which is not yet readily manufactured), or a readily manufactured component carrier (such as a printed circuit board (PCB) or an integrated circuit (IC) substrate). However, it is also possible that the component carrier structure is a coupon.

In the context of the present application, the term "quality test" may particularly denote an assessment of the quality of a component carrier structure by analyzing a characteristic of one or more pre-defined test targets thereof. In such a quality test, it may be tested whether or not one or more such characteristic features of the component carrier structure meet(s) one or more quality criteria. Such quality criteria may include one or more qualitative quality criteria (such as presence or absence of a delamination of a layer structure as a qualitative error pattern or failure scenario) and/or one or more quantitative quality criteria (such as a thickness of a patterned copper layer in relation to a pre-defined range of acceptable thicknesses). Examples for determinable quality defects of component carrier structures are artefacts in terms of drill holes, hair inclusions, solder resist effects, short-circuiting between electrically conductive traces to be separated, etc. For example, a quality test of the component carrier structure may be carried out to check whether the component carrier structure complies with an industrial norm (for example IPC 6012, IPC-A-600, IPC-2221, etc.).

In the context of the present application, the term "pre-defined test target" may particularly denote a structural feature in an interior of the component carrier structure, exposed by material removal, which has been pre-defined as a characteristic item for assessing a quality of the component carrier structure. For example, a test target may be a drill hole or a layer structure in a (in particular laminated) layer stack of the component carrier structure comprising at least one electrically conductive layer structure (for instance a patterned copper foil and/or a copper filled laser via) and/or at least one electrically insulating layer structure (for instance a sheet comprising resin, such as epoxy resin, and optionally reinforcing particles such as glass fibers). In particular, a characteristic or an attribute of at least one test target of the component carrier structure may comprise one or more of a diameter of a drill hole (such as a laser drill hole or a mechanical drill hole, which may or may not be filled with an electrically conductive material such as copper), a distance between adjacent drill holes, a thickness of a layer structure (in particular a thickness of a patterned copper foil or layer), a planarity of a layer structure (for instance measured by means of a deviation of a layer structure from a purely planar configuration), delamination of a layer structure (i.e. a layer structure which has detached at least partially from an integral set of for instance laminated layer structures), etc.

In the context of the present application, the term "removing material for exposing a plane" may particularly denote a material removal in a horizontal, vertical or diagonal direction of the component carrier structure. Hence, the exposed plane can have any orientation (in particular horizontal, vertical, or diagonal).

In the context of the present application, the term "component carrier structure specific data" may particularly denote any kind of experimentally captured data being appropriate for deriving information concerning one or more properties of the component carrier structure, in particular the exposed surface thereof. Such detection data may allow to characterize the component carrier structure based on an analysis of its exposed surface. In particular, the component carrier structure specific data may be image data being indicative of an image of the exposed surface of the component carrier structure or part thereof. Additionally or alternatively, component carrier structure specific data may be or may comprise electric detection data captured at the exposed surface of the component carrier structure, for instance obtained by scanning the exposed surface with a probe detecting electric signals. For instance, it may also be possible to determine certain properties of a component carrier structure by detecting electric signals indicating for instance a thickness of a dielectric layer structure, indicating a delamination, etc.

In the context of the present application, the term "defect of a test target" may particularly denote a discrepancy (in particular a quantitative or a qualitative discrepancy) between an expected attribute and an actual attribute of the test target. For instance, a defect of a drill hole may be present, if the diameter thereof differs from a target diameter value, in particular by more than a predefined threshold value. In another example, a defect of a copper layer may be present, if the copper layer is delaminated from a laminated layer stack rather than being properly connected with the stack.

In the context of the present application, the term "identifying a defect" may particularly denote a process of discovering, finding out or figuring out that a defect of at least one test target is present.

In the context of the present application, the term "evaluating a defect" may particularly denote a process of analyzing a previously identified defect of at least one test target qualitatively and/or quantitatively with respect to at least one criterion. For example, such a criterion may relate to the origin of the defect or to the question whether the defect harms the quality of the component carrier structure in an inacceptable way or is acceptable. Thus, the mere identification of a defect of a test target may not yet be considered as sufficient for classifying the entire component carrier structure as waste, in contrast to this a defect evaluation may judge the relevance of the defect(s) in terms of quality. For instance, one or more of the criteria mentioned in chapter "3.6 Structural Integrity" of IPC-6012D (version: September 2015) may be considered.

According to an exemplary embodiment of the invention, a fully automated system of testing quality of a component carrier structure (such as a printed circuit board or a coupon) is provided which can determine quality of the component carrier structure substantially without user intervention. In particular, the entire process of creating, measuring and analyzing a for instance ground and polished component carrier structure may be carried out in an automated way. This may allow to ensure a sufficiently accurate execution of a quality test, while simultaneously achieving a high throughput on an industrial scale in terms of quality testing of component carrier structures at any stage during a manufacturing process. For this purpose, a component carrier structure may be subjected to a machine-controlled material removal (for example, but not limited to, abrasive material removal) process to reach a target examination plane of interest. Hence, material removal may be accomplished for exposing an interior of the component carrier structure to thereby obtain access to at least one test target (in particular a hole, for instance a drill hole which may be formed by laser drilling or mechanically drilling, or an etch hole which may be formed by (in particular plasma) etching) under examination. Also in a fully automated manner, one or more test targets may then be determined from the component carrier structure after exposing said plane of interest. An evaluation unit may then evaluate the results of this determination to derive a result of the quality test. In this context, defects may be (i) identified and (ii) evaluated by a processor-based evaluation unit. Thus, the evaluation unit carries out at least two tasks. A first task (i) is the identification of a defect of a test target, i.e. the presence of a defect. An additional second task (ii) is the characterization of a previously identified defect by analyzing one or more attributes of said defect for assessing the significance of the defect in terms of the quality judgement concerning the component carrier structure as a whole. Highly advantageously, none of the mentioned processes in terms of validity assessment of the component carrier structure requires any user intervention. This not only reduces human resources effort in terms of quality testing of component carrier structures, but also renders the quality test more objective, hence more meaningful and faster.

In the following, further exemplary embodiments of the method, the apparatus, the computer-readable medium, and the program element will be explained.

In an embodiment, the evaluation unit is configured for analyzing a cause for the at least one defect. In other words, the evaluation unit may not only be capable of identifying a defect of a test target, but may also analyse the origin of the defect. Undesired phenomena such as only partial via filling or laminated layer delamination may have a cause in the manufacturing process which may be reflected in the structural details of the defect. Identifying not only the presence of a defect but also its cause during a manufacturing process may allow to derive information how the manufacturing process should be modified for suppressing the identified defect in the future. Highly advantageously, the evaluation unit may access a database for this purpose in which data sets may be stored which correlate attributes of test target defects with manufacturing data. Such a database may also include data indicating which changes of manufacturing processes resulted historically in the suppression of defects with specific properties.

In an embodiment, the evaluation unit is configured for assessing the quality, and in particular for analyzing a cause for the at least one defect, by an artificial intelligence module. In particular, the artificial intelligence module may comprise at least one of the group consisting of a deep learning tool, a machine learning tool, an expert knowledge tool, and a neural network. In the context of the present application, the term "artificial intelligence" may particularly denote tools such as neural networks, self-learning or self-adaptive systems, fuzzy logic, etc. Artificial intelligence may operate independently of human beings on the basis of electronic hardware and software resources. Correspondingly, an artificial intelligence module may be a physical or a virtual entity including artificial intelligence capabilities. Artificial intelligence may particularly denote the implementation of algorithms and/or statistical models that a processor (such as a computer system) may use to perform a specific task without using explicit instructions, relying on patterns, or the like. In particular, artificial intelligence algorithms may build a mathematical model based on input data (which may also be denoted as training data) in order to make predictions or decisions without being explicitly programmed to perform the task. In an embodiment, processing by the artificial intelligence module comprises processing by deep learning. Deep learning may particularly denote machine learning methods based on artificial neural networks with representation learning. Deep learning can be supervised, semi-supervised or unsupervised. Examples of deep learning architectures, which may be implemented according to exemplary embodiments of the invention, are deep neural networks, deep belief networks, recurrent neural networks and convolutional neural networks. The implementation of deep learning algorithms in the automatic execution of a quality test, in particular in terms of interpretation of pre-determined test targets concerning quality of the component carrier structure, may further improve the reliability, performance and accuracy of the quality test. In an embodiment, processing by the artificial intelligence module comprises processing by a neural network. Such a neural network may be a computing system which may be capable of learning to perform tasks by considering examples, generally without being programmed with task-specific rules. A neural network may be based on a collection of connected nodes called artificial neurons. Each connection between said neurons can transmit a signal to other neurons. An artificial neuron that receives a signal then processes it and can signal neurons connected to it. During learning, the weights of the connections may be continuously adjusted. By inputting the previously determined test targets of the component carrier structure under analysis, the neural networks can contribute to assess quality of the component carrier structure.

In an embodiment, the artificial intelligence module is configured for evaluating the quality by accessing a database comprising empirical data, in particular at least one of cross-sectional images, and a failure or defect catalogue. Empirical data may be a collection of historic data sets correlating defect attributes with defect causes. Cross-sectional images included in the database may show defect or failure characteristics on a visual level and may allow to find a best match between a present feature or defect and one or several of stored cross-sectional images. A defect or failure catalogue may include a list of typical defects or failures which may occur (or which actually occurred historically) in a component carrier manufacturing plant. Each of such failures may be correlated with corresponding data (for instance metadata), which may for instance include strategies of how to overcome the corresponding failure by modifying manufacturing parameters.

In an embodiment, the evaluation unit is configured for assessing the quality in terms of compliance with one or multiple user-defined compliance conditions. Hence, freely definable user requirements may be considered as well when analyzing defects of test targets in the framework of a quality test of the component carrier structure. This increases the flexibility of the defect evaluation since user-defined quality preferences may be included in the evaluation of the relevance of a defect. In particular, the mentioned evaluation may analyse whether identified defects of test targets violate user-defined requirements or are still compatible with user-defined requirements.

In an embodiment, the evaluation unit is configured for assessing the quality in terms of compliance with at least one industrial standard, in particular at least one of IPC-6012 and IPC-A-600 (each of the mentioned industrial standards in particular in the latest version in force at the priority date of the present patent application). Thus, the defect evaluation may verify conformity with an industrial standard. More specifically, said evaluation may figure out whether identified defects of test targets render the assigned component carrier structure non-conformal with industry-standard requirements or are still within a specification defined by a respective industrial standard. Hence, standard-related quality requirements may be included in the evaluation of the relevance of a defect.

In an embodiment, the evaluation unit is configured for evaluating the quality by classifying each of the at least one determined defect in one of at least two classes of defect severity, in particular comprising a first class of quality-critical defects and a second class of quality-uncritical defects. A defect may be classified as critical or uncritical based on a type of a specific defect and/or based on the intensity of a specific defect. In such a preferred embodiment, the identification of a defect will not automatically result in a classification of an assigned component carrier structure as waste or scrap in a rough yes-or-no approach. In contrast to this, the evaluation unit may analyse in a semantic way whether the present defect must be in fact considered as so severe that the component carrier structure has to be classified as deficient product, or whether the defect is only of minor relevance for the overall quality of the component carrier structure which can thus be accepted as a usable product in spite of the defect. By classifying defects into different levels of severity, the yield in a manufacturing process may be increased without compromising on critical quality attributes.

In an embodiment, a defect relating to a structural deviation below a predefined threshold value and relating to an electrically insulating layer structure of the component carrier structure is classified as a quality-uncritical defect. Highly advantageously, a first criterion for classifying a defective component carrier structure nevertheless as passing the quality test may be of which material the defective test target is made. In component carrier structures such as printed circuit boards (PCBs), defects in electrically insulating material (such as prepreg or FR4) may be generally considered less critical than defects in electrically conductive material (such as copper). The reason for this distinction is that the functionality of a component carrier structure is dominated by the electrically conductive layer structures. In an embodiment, a defect relating to an electrically conductive layer structure (in particular a copper structure) of the component carrier structure may thus be classified always as a quality-critical defect. However, also excessive defects of electrically insulating material may be nevertheless inacceptable. For that reason, a second criterion for classifying a defective component carrier structure nevertheless as passing the quality test may be that the identified defect in an electrically insulating layer structure remains quantitatively within defined limits. If for instance a thickness of an electrically insulating layer structure separating two electrically conductive layer structures from each other becomes much too small in comparison with a specification, this may have an undesired impact on the electric reliability of the component carrier structure as a whole, since undesired electrically conductive paths may then not be reliably excluded for instance in high voltage applications. In such a scenario, the component carrier structure may be classified to fail passing the quality test. In an embodiment, a defect relating to a structural deviation above a predefined threshold value and relating to an electrically insulating layer structure of the component carrier structure may hence be classified as a quality-critical defect. If however the thickness of an electrically insulating layer structure separating two electrically conductive layer structures is only slightly too large or includes small dielectric inclusions or voids, such a defect may be considered as still acceptable in terms of the overall functionality of the component carrier structure. By considering the degree of severity of a defect for judging whether the component carrier structure passes or fails the quality test, more meaningful conclusions can be drawn. By preventing usable component carrier structures to be classified as "fail" although they are functionally intact view of only minor defects, resources can be used more efficiently and the yield may be increased. By preventing highly defective component carrier structures to be classified as "pass", a high performance and reliability of the quality test of the component carrier structures may be ensured simultaneously.

In an embodiment, the evaluation unit is configured for assessing the quality by classifying the component carrier structure into one of a plurality of pre-defined quality classes, in particular in one quality class of a group of quality classes consisting of "pass", "fail", and "further analysis required". By applying for instance the above described criteria, it may be possible to classify the large majority of component carrier structures under test as "pass" or "fail". However, it may happen that a fully automated quality test apparatus is not in a position or does not have all information required for correctly classifying each and every component carrier structure as clearly "pass" or clearly "fail". If an algorithm or an artificial intelligence module of the evaluation unit has not arrived at a sufficiently clear conclusion concerning a classification of a component carrier structure on the test as "pass" or "fail", it is advantageously possible that such a component carrier structure is classified as "further analysis required". By allowing such a further classification level, false positives and false negatives may be reliably prevented. This may prevent both an unnecessary yield loss as a result of an excessive classification of minor defective component carrier structures as "fail" as well as quality issues resulting from an excessive classification of major defective component carrier structures as "pass". The (usually very few) tested component carrier structures classified as "further analysis required" may for instance be fed back into the automated apparatus for an additional automated analysis (for instance additional material removal for better exposing test targets, capturing additional images of an exposed plane of interest, improving surface quality of an exposed plane of interest by polishing and/or etching before carrying out additional analysis, etc.). Additionally or alternatively, individual tested component carrier structures classified as "further analysis required" may be exceptionally presented to a human operator for making a human decision concerning quality specification. For this purpose, the apparatus may comprise an interface unit (such as a graphical user interface, GUI) configured for enabling a human intervention, in particular when a result of the evaluation is that further analysis or human intervention is required. The result of a human decision of the quality of component carrier structures classified as "further analysis required" may be supplied to the apparatus as learning data for improving the functionality of an artificial intelligence module of the evaluation unit. Specifically such training data are of utmost relevance for a significant and rapid increase of the performance of the machine-based quality specification.

More specifically, the evaluation unit may be configured for evaluating the quality by classifying each test target of the component carrier structure into one of a plurality of quality classes, in particular in one class of a group of classes consisting of "pass", "fail", and "further analysis required". Advantageously, each characteristic, attribute or parameter of a test target to be examined may be classified in this way. The final decision may be made as described in the preceding paragraph, but the judgement concerning the individual characteristics, attributes or parameters may form the basis of such a quality decision. In the event of only slight deviations of less critical parameters it can be decided that a component carrier structure can be evaluated with "pass". Criteria as a basis for such a decision may be predefined by a user or by a specification indicative of quality.

In an embodiment, the evaluating unit is configured for accessing a database storing a plurality of predetermined defect characteristics as a basis for identifying a defect of a test target. For instance, a test target may be a copper filled drill hole. Corresponding defects may be for instance an inappropriate shape of the drill hole, an inappropriate diameter of the drill hole, and inappropriate copper filling (for instance interior voids) of the drill hole, etc. When storing such characteristic defects for each test target in a database, the identification of defects may be enabled with low computational burden. In the database, such defects may have assigned additional data, such as potential origins of such a defect, strategies of overcoming such defects by changing the manufacturing process, etc.

In an embodiment, the determining unit is configured for determining the at least one test target by automatic image recognition. Comparison images may be stored in a database which can be accessed by the determining unit.

In an embodiment, the apparatus comprises a manufacturing control unit configured for controlling a manufacturing process of manufacturing component carriers and configured for adjusting said manufacturing process based on a result of the evaluating. When defects of test targets of component carrier structures have been identified and classified, and in particular when their origin or cause has been analysed, an adaptation of process parameters of a process of manufacturing component carrier structures may be correspondingly adapted for preventing such defects for future manufacture of component carrier structures. In this context, the manufacturing control unit may access a database correlating historically identified defects with historically successful modifications of the manufacturing process for suppressing such defects.

In an embodiment, the material removal unit is configured for removing material of the component carrier structure by grinding. In particular, grinding may denote an abrasive machining process that may use a grinding wheel (or another grinding body) as material removal or cutting tool. Each grain of abrasive may function as a microscopic single-point cutting edge, and shears a tiny chip from the component carrier structure. However, in other embodiments, material removal from the component carrier structure may be accomplished by other methods than grinding, for instance by laser processing or any kind of cutting.

In an embodiment, the material removal unit is configured for removing material of the component carrier structure by one of the group consisting of cross-sectional grinding and flat grinding. What concerns cross-sectional grinding, a cross section of the component carrier structure may be created that allows analysis at a plane that cuts through the plate-shaped component carrier structure. Cross-sectional grinding is a destructive technique cutting or grinding away a portion of the component carrier structure to expose an internal plane of interest for analysis. In an obtained cross section, the quality of drill holes can be assessed, the plating quality and thickness in vias can be assessed, and other test targets can be analyzed as well. As an example for such other test targets, voids in the materials of the component carrier structure may be made accessible which indicate the quality of a lamination process. What concerns flat grinding or surface grinding, such a technique may be used to produce a smooth finish on a flat surface of the component carrier structure. Flat grinding may be denoted as an abrasive machining process in which a spinning wheel (or any other body) covered with rough particles cuts chips from a main surface of the component carrier structure thereby accessing a main surface of an interior layer of the component carrier structure.

In an embodiment, the apparatus comprises a polishing unit configured for polishing an exposed surface of the component carrier structure after removing material. Polishing may denote the process of creating a smooth surface by rubbing it or using a chemical action, leaving a surface with a reduced roughness. In contrast to grinding, polishing does not remove a noteworthy amount of material from the surface of the component carrier structure, but simply enhances planarity by flattening the surface. Polishing may use multiple stages, starting with a rougher abrasive, wherein each subsequent stage may use a finer abrasive.

In an embodiment, the apparatus is configured for carrying out the quality test without human intervention. Correspondingly, the method may comprise carrying out the quality test without human intervention. This avoids human errors and increases the throughput.

In an embodiment, the component carrier structure comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier structure is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier structure is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias or other through hole connections. The (for instance partially) filled hole may connect the whole stack (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers) or other reinforcing particles (such as reinforcing spheres, in particular glass spheres).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal, and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylether PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials (wherein "DK" may refer to the real part of the dielectric constant) may be applied in the component carrier as electrically insulating structures.

In an embodiment, the at least one electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay could be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a mi-croelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 illustrates a flowchart of a method of carrying out a quality test of a component carrier structure according to an exemplary embodiment of the invention.
Figure 2 schematically illustrates an apparatus for carrying out a quality test of a component carrier structure according to an exemplary embodiment of the invention.
Figure 3 illustrates details of an apparatus for carrying out a quality test of a component carrier structure according to an exemplary embodiment of the invention.
Figure 4 illustrates an apparatus for testing quality of a component carrier structure according to an exemplary embodiment of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a system for identifying defects in an interior of a component carrier structure (such as a printed circuit board) is provided. After exposing a plane of interest in said interior by removing (for instance by abrasion) material from the component carrier structure (for instance by creating a microsection), an image of said plane of interest may be captured and may be analyzed in terms of one or more tests targets visible on said image. After such a determination of the test target(s), a quality of the component carrier structure may be evaluated by analyzing one or more defects, artefacts, structural inaccuracies, violations of specifications, or errors of the determined test target(s). In a preferred embodiment, defect valuation is not only carried out in a yes-no-fashion. In contrast to this, a judgment of the question may be conducted whether a detected defect is so severe (for instance significant defects in copper structures) that the component carrier structure or at least a respective test target has to be considered as waste or scrap, or whether the defect can be accepted, for instance due to its nature, insignificance for the overall function of the component carrier structure, or due to its minor character (for instance point defects in resin). By such a valuation in terms of testing quality, more meaningful results may be obtained and high yields may be achieved without compromising on quality-relevant product attributes.

In embodiments, a result of the defect valuation may be that an individual test target or even the entire component service structure passes or fails the test. It is however also possible that an output of the defect valuation is that further analysis is required, for instance by a human operator. It is also possible to evaluate defects in terms of compatibility with industrial standards and/or user-defined constraints. This increases the flexibility of the quality test. In order to further improve the performance of the defect valuation task, artificial intelligence may be implemented. Advantageously, an artificial intelligence module such a neural network may be trained with data derived from expert knowledge and/or with empirical data. By taking this measure, the reliability of an output of the defect valuation in terms of the quality test may be continuously improved. What concerns defect valuation, an identified defect may result in a classification of an individual test target or even the entire component carrier structure in one of multiple classes, which simplifies an automated further processing of the result of the defect valuation. For instance, the process of manufacturing component carriers in a manufacturing line may be adjusted (for instance by modifying a chemical bath or electrolyte, by changing laser drill parameters, or by modifying any other process parameters) if severe defects are detected in a component carrier structure subjected to a quality test. For instance, attributes of a test target (such as drill hole diameter in a cross-sectional plane, or structural integrity of a metal pattern in a surface grinding structure) may be analyzed. Reliability of a result of the defect valuation may be further improved by taking into account a database including defect images or other kinds of defect characteristics. Examples for identified and evaluated defects are cracks, delamination of layers, an erroneous layer sequence or build up, an erroneous layer thickness, or an inhomogeneous drill hole. Also the determination of a cause for a defect may be the result of the defect valuation and may be highly valuable information in terms of controlling component carrier manufacture.

In embodiments, error data of an analyzed component carrier structure may be used as meaningful information for an automated quality test. In this context, an error or a defect may be detected, valuated and categorized. Usable error categories may be that the component carrier structure has passed or failed the quality test, that a meaningful statement concerning component carrier structure quality requires additional analysis, etc. Also IPC categorization may be implemented in such an automated quality test apparatus. Highly advantageously, such a system may also learn from cross-sectional photos, for instance by implementing elements of artificial intelligence.

According to an exemplary embodiment of the invention, a system for detection, analysis, classification and judgement of PCB-related attributes and failures may be provided. In particular, a self-improving system may be implemented based on expert knowledge, specifications and already gathered libraries (which may include cross-sectional pictures, failure catalogues, etc.). Preferably, AI-methods (such as deep learning) may be implemented to analyze, classify and judge cross-sectional images. In particular, this may include measurement of important process and product criteria (for example dielectric thickness, copper thickness) as well as a detection and classification of critical faults and defects (for example cracks, delamination, etc.) to enable an objective and data-driven judgment of process and part quality. Elements of artificial intelligence and expert knowledge may contribute to a continuous improvement of the system quality.

Examples for variables having an influence on cross-sectioning of component carrier structures (see a more detailed discussion of the individual variables below) are a grinding body used for material removal, alignment (for instance making use of a handling arm), pressure applied during grinding and/or polishing, rotation speed during grinding and/or polishing, control in particular of a material removal from a component carrier structure (more specifically material removal progress control), cleaning (of component carrier structure and/or grinding body) to avoid carryover, heating or cooling, and thermal and mechanical loads.

What concerns grinding, adjustable parameters are grain size, contact pressure, and rotation speed of abrasive medium. Grain may also be adjusted for a grinding machine. Polishing of a cross-sectional surface of the component carrier structure may be carried out using a diamond suspension (wherein rotation may be synchronized or reciprocal). Optionally, immersion and/or filling of a component carrier structure may be possible to prevent smearing of copper holes.

With respect to a used grinding body for material removal, it may be advantageous that the material removal process does not generate excessive heat to keep the laminate of the component carrier structure intact. Preferably, the material removal process may be carried out at a temperature significantly below the glass transition temperature Tg (for example at least 10% below Tg on the Celsius scale or on the Kelvin scale) of the resin material of the component carrier material. For example, water can be used as a cooling and/or cleaning medium.

For removing material of the component carrier structure, grinding may be preferred. However, material removal can also be accomplished by (for instance wire) cutting, wire eroding, plasma treatment, laser treatment, sandblasting, water jetting, milling, sawing, treatment by gate shears, ion beam treatment and/or punching.

Preferably, the grain size may be (in particular at the end of the material removal) fine enough that subsequent polishing is supported. Grain size may be selected depending on a used polishing suspension. For example, 3 µm grains may be applicable for only a certain degree of grinding.

In order to suppress a variance of planarity of a ground and/or polished surface of the component carrier structure, it may be advantageous to avoid excessive heat and cold. Furthermore, thermal and mechanical loads should be kept low.

When designing a handling arm of the handing unit, slipping and/or turning of the component carrier structure should be kept as low as possible. This advantageous boundary condition may influence the choice of a maximum rotation speed.

Next, embodiments of the grinding process will be explained. Advantageously, an iterative grinding control process may be carried out. Grinding disks (or plates) may be arranged horizontally or vertically, or at a special angle if required or desired (in view of an implemented type of grinding).

What concerns the control of a progress of the material removal, a camera may be used for monitoring grinding progress. For instance, such a camera may be arranged on and/or in a grinding body. This may promote planarity and/or alignment of the treated surface of the component carrier structure. Progress control may also be accomplished by an electric measurement, for instance by contacting a copper structure which is removed partially or entirely at a certain material removal progress state, which can be detected by a change of an electric signal. Additionally alternatively, progress control may be based on one or more mechanical stops (for instance having a sufficiently hard surface, preferably a diamond surface), against which a grinding body abuts when a predefined progress of the material removal process is achieved. Also a resistance measurement on a grinding body may be used for progress control. In other embodiments, progressive feed may be measured in terms of progress control. For example referring to a through hole, the moment that such a hole is opened may result in a significant pressure drop. When a micro via is reached, the impact on pressure may be the other way around, i.e. a pressure increase, or resistance increase may be detected. Grinding metallic via material rather than softer resin material may increase the pressure. If an electric signal is measured at the micro via and the electrically conductive material of the micro via is removed, the electric resistance may increase, which may be detectable as well. In yet another embodiment of progress control, discoloration for instance of water upon target achievement may be detected. Also a resistance measurement (for instance of a sacrificial structure removed during grinding) may be used for progress control. In yet another embodiment relating to progress control, sound detection, tribometer-based detection, a pin pressing on a grinding disc (optionally combined with a light barrier), etc., may be used. Once a center of a drill hole is detected, then grinding may stop.

Preferably, progress can be measured at or close to a test target. Still referring to progress control of a grinding process, a hard stop may be possible. However, also iterative grinding processes are possible.

In an embodiment, contact pressure between grinding body and component carrier structure may be measured. For instance, this may be accomplished in an automated manner by a pressure regulator (regulating for instance depending on force). During material removal, the pressure can remain constant or may be varied. A smaller number of grinding bodies can be balanced with time, pressure, rotation. It may also be possible to apply a variable pressure depending on throughput, quality target, sample thickness. Maximum pressure may be regulated in such a way that no damage of the component carrier structure occurs, in particular at or around test targets such as drill holes. In particular, the contact pressure can be selected depending on how the component carrier should be ground (for instance grinding along layers, grinding against layers, etc.). Care should be taken that cutting preparation neither enhances nor reduces quality problems in the component carrier structure.

What concerns rotation speed and type, it may be advantageous to generate heat only in a range below a predefined maximum value. A rotation direction may be synchronized or may be opposite. A gripping or handling device (such as a clamping device, a handling fixture, a hexapod, etc.) can oscillate quickly.

Parameters which can be adjusted in terms of rotation are rotation time, contact pressure, type of rotation, material of the component carrier structure, grain, etc.

Concerning alignment or orientation of the component carrier structure during its treatment for carrying out the quality test in an automated way, a camera may determine whether the component carrier structure sample is positioned correctly before a first grinding. If necessary, the position of the component carrier structure may be corrected to ensure a proper alignment (for instance based on a comparison with external reference holes that are preferably not coppered; such reference holes may for instance be drilled or etched in a photo process). Alternatively, a mechanical alignment process (for instance using an alignment pin) may be carried out.

An objective of the alignment may be that a target plane and a grinding medium should be oriented in parallel. This may be achieved by correspondingly influencing medium, grinding body, turning one or even all of the involved components, etc.

Still referring to alignment, a camera image may capture reference points and target points to be viewed. Such data may define a target plane (software-supported, mechanically, etc.) and may bring a target plane parallel to the grinding medium. In the further course of alignment control, limiting factor may be the combination of hexapod/grinding speed/maximum force, so that the alignment remains which corresponds to the mechanical stability of the overall system.

Now referring to cleaning of the component carrier structure, one embodiment may clean the component carrier structure during grinding. In an iterative approach, each new grinding stage (for instance fine grinding following coarse grinding) may be preceded by a cleaning stage. Cleaning may ensure that no carryover of particles takes place. For instance, particles may be blown away, sucked away, evaporated, burnt, stripped off, brushed, rinsed, etc., in terms of cleaning. For instance, continuous cleaning may be carried out during the grinding process. Suction, rinse (preferably bath or sink), strip off, blow away, ultrasonic bath (shake out) or other cleaning units may be implemented. Advantageously, very small cracks may be rinsed out by cleaning. After cleaning, it may be advantageous that the remaining particles should be at the maximum equal in size to or smaller in size than the grain size used for grinding in the next process.

What concerns coupon design, it may be standardized, or may deviate. Any deviation may be coordinated with a user. For instance, a coupon-type component carrier structure may be provided with one or more registration holes, a wear sensor, etc.

Examples for quality criteria or characteristics in terms of assessing quality of a component carrier structure are a sharp edge (preferably 90°), a radius near zero, planarity, a tolerance below a predefined threshold value (for instance 10% or preferably less than 10%, having a tolerance of not more than 7%). A further quality feature of a component carrier structure is that it is should be preferably scratch-free in an image at 100x magnification. Furthermore, the component carrier structure should be free of gaps (in particular between sample and embedding agent, more particularly between conductive layer and embedding agent, especially between copper and embedding agent). Resins may shrink when embedding (fast curing embedding agents have a lot of volume loss, slow curing agents have little volume loss), but shrinkage should not be excessive.

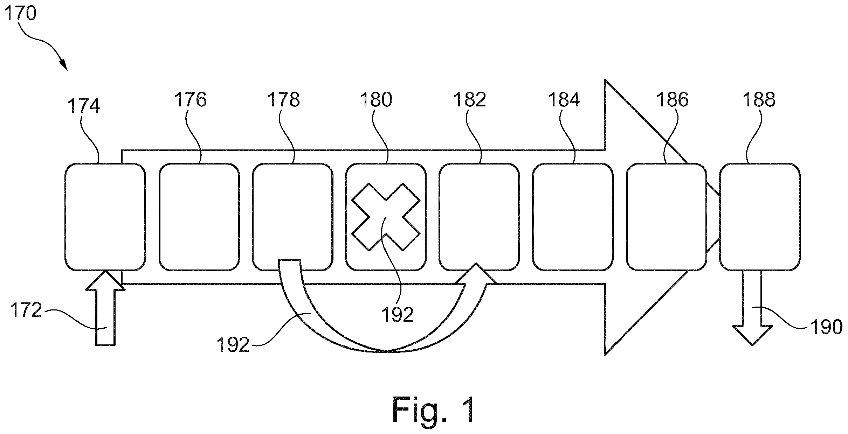

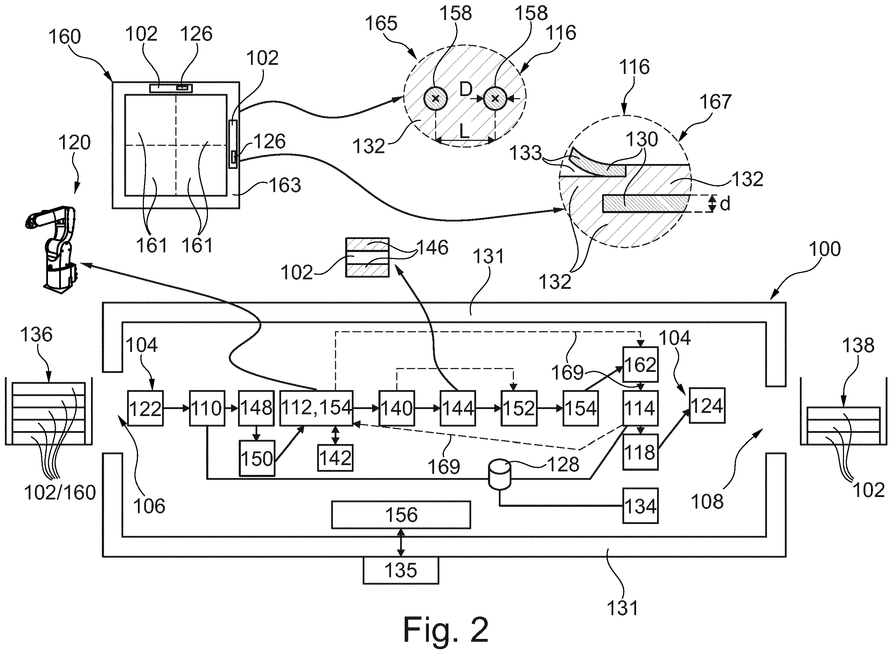

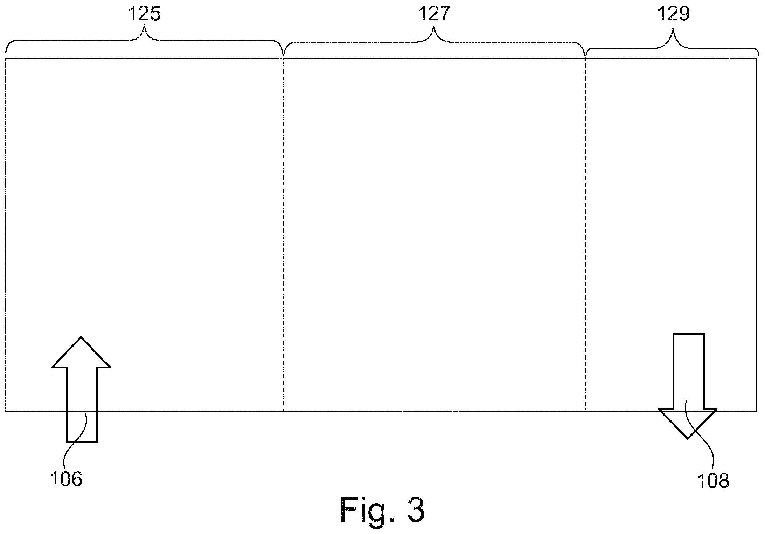

**Figure 1** illustrates a flowchart 170 of a method of carrying out a quality test of a component carrier structure 102 according to an exemplary embodiment of the invention. The reference signs used for the description of Figure 1 refer to the embodiments of Figure 2 or Figure 3. Preferably, the mentioned component carrier structure 102 may be a coupon forming part of a panel and used for testing component carriers (such as printed circuit boards (PCBs) or integrated circuit (IC) substrates). However, the component carrier structure 102 may be alternatively a panel or an array (such as a quarter panel) comprising multiple connected preforms of component carriers, or a preform of a component carrier or a readily manufactured component carrier.

Advantageously, the method of flowchart 170 may correspond to the execution of a quality test of the component carrier structure 102 by an automated apparatus 100. Preferably, the method may comprise carrying out the quality test without human intervention between an inlet 106 - corresponding logically to input 172 - and an outlet 108 - corresponding logically to output 190 - of said apparatus 100. In other words, inlet 106 of apparatus 100 corresponds to input 172 of the method, whereas outlet 108 of apparatus 100 corresponds to output 190 of the method. More specifically, an automated process for cross section preparation and visual inspection as well as measurement of a component carrier structure 102 is provided. Preferably, no manual work occurs, and the entire process may be automated. For this purpose, the test coupon-type component carrier structure 102 may be configured for automated handling and for machine-readable serialization.

As indicated with reference sign 172, the component carrier structure 102 may be input into apparatus 100.

Referring to a block 174, a coupon may be inserted as component carrier structure 102 into the apparatus 100 and may hereby be handled fully automatically by a robot 120. More specifically, the coupon may be a component carrier structure 102 which may for example be constructed or designed in accordance with IPC-2221. The component carrier structure 102 may provide traceability information to the apparatus 100. For this purpose, the method which may be carried out using apparatus 100 may comprise automatically identifying the component carrier structure 102 which shall undergo the quality test. For instance, it may be possible to register the coupon-type component carrier structure 102 in a list. Multiple coupons may be sorted. For traceability purposes, it may be possible to assign information such as lot number, panel number, array number, x/y information, cross section number, a report number, a request identifier, etc., in a data set assigned to a respective component carrier structure 102. For instance, such data sets may be stored in a database 128.

Referring to a block 176, the component carrier structure 102 which may still be integrally connected with the rest of a panel or the like may be singularized or separated, for instance by milling or cutting the component carrier structure 102 out from a larger body 160 such as a panel. For this purpose, it may be possible to search a defined position of the component carrier structure 102 in the larger body 160 and cut it out. As a result, a test sample in form of the separated component carrier structure 102 may be obtained. For instance, cutting out the component carrier structure 102 may be accomplished in accordance with a smallest plated through hole or corresponding to a user definition.

Referring to a block 178, the component carrier structure 102 may then be subjected to thermal stress, for instance by executing a solder float test. For example, the component carrier structure 102 may be immersed in molten solder for subjecting thermal stress to the component carrier structure 102. As an alternative to a solder float test, it may also be possible to carry out an alternative thermal stressing method, e.g. reflow simulation.

Referring to a block 180, the component carrier structure 102 may or may not be subjected to an encapsulation process for simplifying handling and/or for buffering stress during the subsequent quality test. While conventional manual quality tests of component carrier structures may require encapsulation before assessing quality, such an embedding may be omitted according to an exemplary embodiment of the invention involving a fully automatic quality test of the component carrier structure 102. If carried out optionally, the encapsulation process may put the component carrier structure 102 into embedding material, such as resin, for further preparation. However, such an embedding can be advantageously skipped (as indicated with reference sign 192) in other embodiments, since automated handling according to an exemplary embodiment of the invention can also be accomplished without such an encapsulation.

Referring to a block 182, it may then be possible to remove material of the component carrier structure 102 for exposing an interior of the component carrier structure 102 to be subjected to the quality test. More specifically, a microsection (in particular cross-section) of the component carrier structure 102 may be created. For this purpose, the component carrier structure 102 may be ground and subsequently polished up to a defined position (preferably up to a center of a via or drill hole or a pattern). For instance, different stages of sandpaper treatment and polishing may be carried out. For grinding, it may for instance be possible to use sandpaper with different grains (for instance using one or more of the following grains: 60, 180, 1200, 2000).

Referring to block 184, the method may then comprise determining one or more pre-defined test targets 116 (such as plated vias and their properties) of the component carrier structure 102 after said material removal. Furthermore, the method may comprise evaluating characteristics or attributes of the one or more test targets 116 of the component carrier structure 102 for assessing the quality of the component carrier structure 102. When skipping block 180, the method may comprise determining the at least one pre-defined test target 116 based on a non-encapsulated component carrier structure 102, otherwise based on an encapsulated component carrier structure 102. In particular, a visual analysis of the cross-section of the component carrier structure 102 may be carried out, preferably in an automated way. For example, x/y dimension measurements may be carried out (for instance inspecting a build-up, a copper thickness, etc.). In particular, the visual check may include an analysis of certain defects. During said inspection, one or more of the following test targets 116 and assigned characteristics may be considered: multilayer build up; plated through hole properties (like wall properties, land characteristics); quality of surface roughness (for instance, surface roughness may be determined corresponding to the Ra scale and/or corresponding to the Rz scale). In terms of roughness, the roughness value Rz may be used as a criterion for the presence of scratches at an exposed surface (in particular a cross-section) of the component carrier structure 102, whereas the roughness value Ra may be used as a criterion for the quality of the material removal process (in particular grinding process). For instance, a quality criterion may be that the roughness of a surface of the component carrier structure 102 exposed by grinding and/or polishing should not be larger than the roughness of a grinding disc and/or polishing paste used in a preceding material removal stage. If this criterion was not fulfilled, it may be concluded that an artifact has been introduced by an earlier material removal stage. For instance, a measurement resolution of at least 1 µm may be obtained. For example, a quality test may be carried out in accordance with IPC-6012, IPC-A-600, etc.

Referring to block 186, the method may comprise creating and storing a report with pre-defined properties. The report may summarize the quality test and its conclusions. This may ensure a proper documentation of the quality test.

Referring to block 188, the method may then comprise archiving the analyzed component carrier structure 102 and the quality test. In particular, this may involve sample storage, storage of electronic documentation, etc.

As indicated with reference sign 190, the component carrier structure 102 may then be output from the apparatus 100.

**Figure 2** schematically illustrates an apparatus 100 for carrying out a quality test of a component carrier structure 102, here embodied as a coupon, according to an exemplary embodiment of the invention. As indicated by a circumferential casing 131 of the apparatus 100, the entire quality test can be carried out in an automated manner within a closed cell.

On the top left-hand side of Figure 2, a plan view of a planar sheet-like body 160 is illustrated, which can be a panel for manufacturing a plurality of component carriers (such as printed circuit board) in a batch procedure. The illustrated panel may for instance have a dimension of 18 x 24 inch² or more. A central main area of the panel may be subdivided into multiple arrays 161 (four quarter panels in the shown embodiment), each comprising multiple PCBs. In a frame 163 surrounding the component carriers, one or more strip-shaped test coupons may be formed as component carrier structures 102. Advantageously, at least one horizontally extending component carrier structure 102 and at least one vertically extending component carrier structure 102 may be foreseen, so as to make it possible to carry out the quality test to identify potential structural defects in two perpendicular directions.

Referring now to apparatus 100 in further detail, an inlet accommodation unit 136 is arranged at an inlet 106 of said apparatus 100 and is configured for accommodating a plurality of component carrier structures 102 in a stacked fashion prior to testing. Hence, the coupon-type component carrier structures 102 may be inserted into the inlet accommodation unit 136 after separation from panel-type body 160. Alternatively, it is possible to stack the larger bodies 160 each including at least one component carrier structure 102 in the magazine-type inlet accommodation unit 136.

A robotic handling unit 104 is configured for handling the component carrier structure 102 (optionally still connected within body 160) along various portions between the inlet 106 and an outlet 108 of the apparatus 100. In particular, the handling unit 104 is configured for gripping and transferring the component carrier structure 102 to be tested (or the entire body 160) from the inlet accommodation unit 136 through the inlet 106 to a below described identification unit 110. More specifically, the handling unit 104 comprises an inlet handling subunit 122 configured for handling the component carrier structure 102 between the inlet 106 and a below described material removal unit 112. Advantageously, the handling unit 104 comprises one or more robots 120 which may comprise one or more hexapods, one or more linear robots, one or more articulated arm robots, etc. A six-axis robot or hexapod (schematically illustrated in Figure 2 at reference sign 120) may have axes equipped with sensors and being appropriate for handling component carrier structures 102 within fully automated apparatus 100. Advantageously, a hexapod may be used for a material removal process (in particular a grinding process) carried out by material removal unit 112, as such a hexapod can be mechanically stable and at the same time can be adapted very precisely in six axes. Referring to Figure 3, a six-axis robot or hexapod may be used in cross-sectional station 127 for operating material removal unit 112 and/or for operating alignment unit 154. Consequently, preparation of the component carrier structure 102 by material removal may become highly precise and robust against possible misalignments. Furthermore, a linear robot and/or an articulated arm robot (not shown) of inlet handling subunit 122 and/or at outlet handling subunit 124 of handling unit 104 can be used for handling component carrier structures 102 between the individual workstations of the automated apparatus 100.

As already mentioned, the inlet handling subunit 122 of the handling unit 104 forwards the component carrier structure 102 to the identification unit 110. The latter is configured for identifying the component carrier structure 102 for which the quality test shall be carried out. This may ensure traceability. More specifically, the identification unit 110 is configured for identifying the component carrier structure 102 based on the detection of an identifier 126 which may be physically connected to or which may form an integral part of the component carrier structure 102. For instance, such an identifier 126 may be a QR code, a barcode or an alphanumeric to code which can be read out by an optical reader of the identification unit 110. It is also possible that the identifier 126 is a transponder such as an RFID (radiofrequency identification) tag or an NFC (near field communication) tag. In such embodiments, the identification unit 110 may comprise a wireless reader configured for wire-lessly reading out the transponder-type identifier 126 for retrieving identification information. For identifying the component carrier structure 102 based on its identifier 126 and/or for retrieving additional data (for instance specific quality test instructions) assigned to the identified component carrier structure 102, the identification unit 110 may access a corresponding database 128. In particular, the identification unit 110 may be configured for identifying the component carrier structure 102 by matching the detected identifier 126 with correlated identity information which is stored in an assigned data set in said database 128. For instance, such a data set may correlate an identification code readable from the identifier 126 with further information concerning the component carrier structure 102, for instance information concerning its manufacturing history (such as lot number, manufacturing date, manufacturing time, etc.). The identification unit 110 may also be configured for retrieving from the database 128 quality test related information indicative of the quality test to be carried out for the identified component carrier structure 102. Such quality test related information may define a quality test which shall be carried out for the identified component carrier structure 102. Different quality tests may be carried out for different types of component carrier structures 102.

In an embodiment in which the component carrier structure 102 has not yet been separated from the larger body 160 before introducing the component carrier structure 102 through inlet 106 into the apparatus 100, a singularization unit 148 (such as a milling machine or a laser cutter) may be provided and may be configured for singularizing the component carrier structure 102 from the panel-type body 160. For instance, singularization may be accomplished by milling or laser cutting.

Thereafter, the processed component carrier structure 102 may be conveyed by the handling unit 102 to a thermal stress exposing unit 150 configured for exposing the component carrier structure 102 to thermal stress. Preferably, the thermal stress exposing unit 150 is configured for floating the component carrier structure 102 on a thermal stress bath, which may comprise molten solder. Thereby, thermal stress may be subjected to the component carrier structure 100.

The component carrier structure 102 may then be forwarded by the above-mentioned or by another robot 120 of the handling unit 104 to a material removal unit 112. The latter is configured for removing material of the component carrier structure 102 for exposing an interior of the component carrier structure 102 undergoing or subjected to the quality test. In particular, the material removal unit 112 may be configured for removing material of the component carrier structure 102 by grinding, preferably cross-sectional grinding (or alternatively flat grinding).

For improving the precision of the material removal, the component carrier structure 102 may be aligned by an alignment unit 154 which may for instance be configured for determining an alignment marker (for instance a drill hole) of the component carrier structure 102 based on a captured image thereof). Said alignment may be carried out prior to grinding by material removal unit 112. Alignment unit 154 is assigned to the material removal unit 112 and may be configured for aligning the component carrier structure 102 before the material removal process. Hence, an alignment carried out by alignment unit 154 is preferably carried out before the material removal process executed by material removal unit 112. Such an alignment may thus form part of the material removal process, in particular grinding process.

Optionally, a removed material quantification unit 142 may be provided and configured for quantifying an amount of material removed from the component carrier structure 102 during grinding. By determining the amount of ground material, a grinding progress and hence a precise control of the grinding process may be made possible.

After grinding, the component carrier structure 102 may be supplied to a polishing unit 140 configured for polishing an exposed surface of the component carrier structure 102 after removing material. Rather than removing an additional substantial amount of material from the component carrier structure 102 (which occurs during grinding), polishing may reduce surface roughness and may improve surface quality without excessive material removal. A polished surface may provide more or more precise information concerning one or more tests targets 116 used as target features to be analysed in the following.

Only optionally, the component carrier structure 100 may then (or alternatively already before material removal by material removal unit 112) be supplied to an encapsulation unit 144 configured for encapsulating the component carrier structure 102 in an encapsulant 146 so that the component carrier structure 102 is to be detected subsequently in the encapsulant 146. Such encapsulant 146 may be a resin functioning as a stress buffer and simplifying handling of the component carrier structure 102 during a subsequent (and/or during a previous) analysis.

However, it may be alternatively possible and even preferred that such an encapsulation is omitted, since the fully automated quality test apparatus 100 may also be capable of carrying out the quality test of the component carrier structure 102 without encapsulation. Thus, even a non-encapsulated component carrier structure 102 may be subjected to the subsequent processes.

Thereafter, the (encapsulated or non-encapsulated) component carrier structure 102 may be forwarded, for instance by a further robot 120 of the handling unit 104, to a cleaning unit 152 configured for cleaning the component carrier structure 102. For instance, the component carrier structure 102 may be rinsed in an ultrasonic bath.

A further alignment unit 154 may be configured for aligning the component carrier structure 102 before detecting and determining tests targets 116 thereon. For this purpose, one or more alignment features (such as through holes, for instance arranged in corners) of the component carrier structure 102 may be detected and used for spatially aligning the component carrier structure 102.

The aligned component carrier structure 102 may then be imaged. For this purpose, a detection unit 162 may be provided and configured for detecting image data of a (meanwhile exposed by said material removal) interior of the component carrier structure 102.

Such image data may be transmitted to a determining unit 114. The latter may be configured for determining one or more pre-defined test target 116 of the component carrier structure 102. The test targets 116 may be predefined features visible in the imaged cross-section of the component carrier structure 102 and may relate to specifically meaningful features in terms of quality evaluation. Appropriate characteristics or attributes of test targets 116 of the component carrier structure 102 may be a diameter D of a drill hole 158 (in particular a laser drill hole or a mechanically drilled hole, which may be filled by plated copper), a distance L between such adjacent drill holes 158, a thickness d of an electrically conductive layer structure 130 (such as a patterned copper layer) and/or of an electrically insulating layer structure 132 (such as a sheet of prepreg), a planarity of a such a layer structure 130 and/or 132, and a degree of delamination (see reference sign 133) of such a layer structure 130 and/or 132. The mentioned test targets 116 are illustrated in Figure 2 in a top view 165 and in a side view 167, respectively. However, another test target 116 (for instance in the scenario of flat grinding) may be a copper line or a plurality of copper lines and a space in between.

Advantageously, the determining unit 114 is configured for processing the image data for determining or recognizing the pre-defined test targets 116. More specifically, the determining unit 114 may be configured for firstly determining the pre-defined test targets 116 in a coarse manner based on a detected first image of the component carrier structure 102. Moreover, the determining unit 114 may be configured for secondly determining the pre-defined test targets 116 in a refined manner based on a detected second image of the component carrier structure 102 detected after detecting the first image and after etching a surface of the component carrier structure 102. In an alternative embodiment, a one-shot operation of the determining unit 114 may be possible as well, in which the determining unit 114 determines test targets 116 based on a single image. As a basis for the determination, the determination unit 114 may also have access to database 128, for instance to get access to test targets 116 to be considered for the determination.

Highly advantageously and as indicated by a feedback loop 169, the determining unit 114 may be configured for determining the pre-defined test target(s) 116 by iteratively repeating a sequence comprising material removal (optionally including polishing and/or cleaning and/or etching), image detection, and image analysis. By such an iterative approach (which can be terminated when a sufficient accuracy is achieved), the reliability of the quality test may be significantly improved.

As further shown in Figure 2, an evaluation unit 118 is provided which is configured for evaluating the determined test target(s) 116 of the component carrier structure 102 for assessing the quality of the component carrier structure 102. The evaluation unit 118 may be advantageously configured for evaluating a quality of the component carrier structure 102 based on properties of the determined test target(s) 116. More specifically, the evaluation unit 118 may be configured for evaluating the quality by classifying the component carrier structure 102 into one of a plurality of quality classes. Highly appropriate may be an automated classification of a respective component carrier structure 102 (and/or an assigned larger body 160) in one class of a group of classes consisting of "pass" (indicating that the component carrier structure 102 and/or the larger body 160 has/have passed the quality test), "fail" (indicating that the component carrier structure 102 and/or the larger body 160 has/have not passed the quality test), and "further analysis required" (indicating that the component carrier structure 102 and/or the larger body 160 need additional quality analysis, since the evaluation unit 118 is not yet in a position to decide in a meaningful way about the quality). In the latter case, it may also be possible to convey the component carrier structure 102 to a human operator for human analysis. The described communication and user impact can be exchanged between the user and the apparatus 100 by an input/output unit 135 being communicatively coupled with control unit or processor 156.

In particular, the evaluation unit 118 may be configured for evaluating the quality by classifying each test target 116 individually or preferably each attribute or characteristic of each test target 116 of the component carrier structure 102 individually into one of a plurality of quality classes, in particular in one class of a group of classes consisting of "pass", "fail", and "further analysis required". Only slight deviations of uncritical parameters may still allow to classify a component carrier structure 102 as "pass". Such a quality test may comprise multiple criteria, which may be judged individually to enable fine-gained decisions on quality and performance.

For supporting its evaluation tasks, the evaluation unit 118 may comprise an artificial intelligence module 134 configured for carrying out the evaluation using artificial intelligence, for instance making use of a neural network. Training data, etc., for training the artificial intelligence module 134 may also be stored in database 128.

By an optional etching process of etching the exposed surface of the component carrier structure 102, additional features on the analysed exposed surface of the component carrier structure 102, such as grain boundaries and plating lines, may become visible. This may render the evaluation of the characteristics of the test targets 116 by the evaluation unit 118 even more accurate.

After said evaluation, the analysed component carrier structure 102 may be transported out of the apparatus 100. For this purpose, the handling unit 104 is provided with an outlet handling subunit 124 configured for handling the component carrier structure 102 by means of at least one additional robot 120, for instance between the material removal unit 112 and the outlet 108. As shown, the apparatus 100 comprises an outlet accommodation unit 138 (for instance also of a magazine-type) arranged at the outlet 108 and configured for accommodating a plurality of component carrier structures 102 in a stacked fashion after testing. The handling unit 104 may be configured for transferring a tested component carrier structure 102 through the outlet 108 to the outlet accommodation unit 138. This may be accomplished for example by further robot 120.

As indicated with reference sign 156, the apparatus 100 may comprise one or more processors or a part of a processor which may be considered as a control unit for controlling operation of the apparatus 100 and its above-described constituents during the quality test of the component carrier structure 102.

Highly advantageously, the apparatus 100 may be configured for carrying out the quality test without human intervention between the inlet 106 and the outlet 108. Only optionally, a user access may be possible via input/output unit 135. The automated character of the apparatus 100 may accelerate the quality test and may render the quality test more accurate while reducing human resources required in terms of quality testing. Furthermore, the throughput may be increased.

**Figure 3** illustrates details of an apparatus 100 for carrying out a quality test of a component carrier structure 102 according to an exemplary embodiment of the invention. Figure 3 illustrates a specific embodiment showing elements of the apparatus 100 of Figure 2.

An input section 125 relates to a portion of the apparatus 100 between inlet 106 and material removal. A cross-sectioning station 127 corresponds so a subsequent portion of the apparatus 100 at which a cross-section of the component carrier structure 102 is created in a fully automated way by grinding and subsequently polishing. An output section 129 relates to a portion of the apparatus 100 between cross-sectioning station 127 and outlet 108.

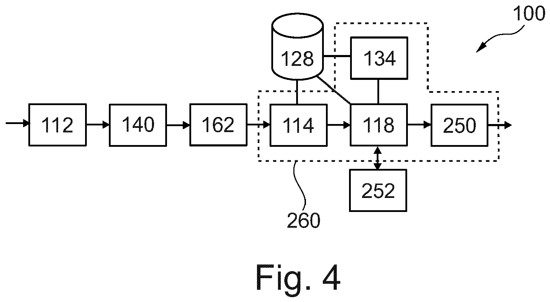

**Figure 4** illustrates an apparatus 100 for testing a quality of a component carrier structure 102 according to an exemplary embodiment of the invention. More specifically, Figure 4 shows only part of such an apparatus 100, wherein further elements of the apparatus 100 of Figure 2 may also be combined with the elements shown in Figure 4. Figure 4 focuses on processes in terms of the defect assessment of test targets 116 of the component carrier structure 102. By analyzing defects determined for the test targets 116, the quality of the assigned component carrier structure 102 may be reliably assessed.

The apparatus 100 for testing quality of component carrier structures 102 which is shown in Figure 4 comprises a material removal unit 112 configured for removing material of the component carrier structure 102 for exposing a plane in an interior of the component carrier structure 102. In other words, a microsection of the component carrier structure 102 may be created for example by grinding, preferably cross-sectional grinding. Following said material removal, the exposed plane of interest of the component carrier structure 102 may be polished by polishing unit 140 for reducing surface roughness and improving surface quality for conditioning the component carrier structure 102 for a subsequent analysis.

In terms of said analysis, a detection unit 162 may capture an image and may therefore detect image data of the exposed plane of the component carrier structure 102. Detection unit 162 may comprise a camera. Additionally or alternatively, detection unit 162 may detect other kinds of data specifying or characterizing the component carrier structure 102 and in particular the exposed surface thereof. For instance, the exposed surface may be scanned by an appropriate probe for detecting electric data which may be used, additionally or alternatively to image data, for a subsequent determination and evaluation procedure described below.

Thereafter, a determining unit 114 may determine one or more pre-defined test targets 116 of the component carrier structure 102 at the exposed plane based on the image data. For instance, the determining unit 114 may search for tests targets 116 of specific shape and/or colour and/or contrast, for example by implementing pattern recognition and/or other elements of automatic image processing or recognition. For this purpose, the determining unit 114 may access data sets (for instance being indicative of predefined outlines of test targets) stored in database 128.

An evaluation unit 118 may then (i) identify and (ii) evaluate one or more defects of the determined test target(s) 116 for assessing quality of the component carrier structure 102. Thus, the evaluation unit 118 carries out at least two tasks. A first task (i) is the identification of a defect of a test target 116, i.e. the process of discovering that a defect is present. An additional second task (ii) is the characterization of a previously identified defect of a test target 116, i.e. the process of analyzing one or more attributes of said defect(s) and in particularly carrying out a relevance assessment of the defect(s) in terms of the quality test of the component carrier structure 102. In the latter process, the significance of the defect of the test target 116 may be assessed what concerns quality of the component carrier structure 102. In this context, the evaluation unit 118 may also analyse a cause for the identified defect(s). This may provide meaningful information in terms of judging quality. For assessing the quality, and in particular for analyzing a cause for the respective defect, the evaluation unit 118 may make use of an artificial intelligence module 134. For example, the artificial intelligence module 134 may comprise one or more of a deep learning tool, a machine learning tool, an expert knowledge tool, and a neural network. The artificial intelligence module 134 may evaluate the quality making use of data being accessible by database 128. Database 100 may store empirical data, for instance cross-sectional images and a failure catalogue, which may support the evaluation unit 118 during evaluating the quality of the component carrier 102.

It is also possible that the evaluation unit 118 is configured for assessing the quality of the component carrier 102 in terms of compliance with user-defined (for instance customer-defined) compliance conditions. By taking this measure, the flexibility of using apparatus 100 for a user may be improved. For instance depending on the particularities of a specific application, a user may define compliance criteria (for instance structural and/or electrical requirements, or requirements in terms of high-frequency behaviour and/or heat removal behaviour) which shall be fulfilled by component carrier structure 102 or component carriers formed on the same panel. A sufficiently high quality of a component carrier structure 102 may require compliance with at least one user-defined compliance criterion for a certain application.

Additionally or alternatively, the evaluation unit 118 may be configured for assessing the quality in terms of compliance with at least one industrial standard (for example IPC-6012 and/or IPC-A-600). Such industrial standards may for instance include definitions for the product classes, and general requirements for instance on documentation, qualification assessment, quality assurance, etc. In particular, IPC-6012 (in particular in the latest version being in force at the priority date of the present patent application) and IPC-A-600 (in particular in the latest version being in force at the priority date of the present patent application) are relevant industrial standards for the manufacture of printed circuit boards (PCBs). Even more specifically, IPC-6012 relates to the qualification and performance specifications for rigid printed boards. Topics of the IPC-6012 industrial standard include material requirements, visual inspection requirements, solder mask requirements, electrical requirements and electrical tests to be performed, cleanliness requirements, and applicable tests. A sufficiently high quality of a component carrier structure 102 may require compliance with one or more of the mentioned and/or other industrial standards. Such a requirement may be involved in the defect evaluation. In other words, a component carrier structure 102 may be considered as fulfilling a quality test if the defects of its test targets 116 do not contradict requirements of a selected industrial standard.

Furthermore, the evaluation unit 118 may be configured for evaluating the quality by classifying the one or more determined defects of the component carrier structure 102 in one of different predefined classes of defect severity. For example, a first class may correspond to quality-critical defects and a second class may correspond to quality-uncritical defects. However, a defect may be classified as critical or uncritical based on a type of a specific defect and/or based on the intensity of a specific defect. For instance, a defect relating to a structural deviation below a predefined threshold value (for instance a sufficiently small thickness deviation of a layer) and relating to an electrically insulating layer structure (such as a prepreg layer, compare layer structure 132 in Figure 2) of the component carrier structure 102 may be classified as a quality-uncritical defect. In contrast to this, a quality-critical defect may be a defect relating to a structural deviation above a predefined threshold value (for instance a sufficiently large thickness deviation of a layer) and relating to an electrically insulating layer structure (such as a prepreg layer, compare layer structure 132 in Figure 2) of the component carrier structure 102. Also any defect relating to an electrically conductive layer structure (such as a copper layer, compare layer structure 130 in Figure 2) of the component carrier structure 102 may be classified as a quality-critical defect, since electrically conductive layer structures usually have a high functional impact on a component carrier structure 102 such as a PCB. Based on an application of said classification of defects, the evaluation unit 118 may assess the quality by classifying the component carrier structure 102 into one of a plurality of pre-defined quality classes. Class "pass" may indicate that the component carrier structure 102 has passed the quality test (for instance although less severe defects have been identified). Class "fail" may indicate that the component carrier structure 102 has not passed the quality test (for instance as a consequence of the identification of a severe defect of a test target 116 of the component carrier structure 102) as a whole. Class "further analysis required" may indicate that the component carrier structure 102 or an individual test target 116 needs additional quality analysis, since the evaluation unit 118 is not yet in a position to decide in a meaningful way about a defect and/or quality.

It is also possible that one or more sub-classes are defined for a certain class. A classification may thereby become refined and consequently even more meaningful. For instance, a component carrier structure 102 classified as "pass" but having characteristics which are close to a limit of a pre-defined specification may be classified as "barely passed". This may allow to become early aware of potential manufacturing issues which can thereby be overcome in due time, for instance by correspondingly modifying a process control. Hence, such a refined specification may allow an early warning. Thus, subclassifications may be transmitted to a manufacturing process as an early warning system.

A corresponding component carrier structure 102 or coupon may also function as an intelligent or smart workpiece (for instance being aware, by its unique identifier, of its function or destination).

For evaluating identified defects of a respective test target 116 or the component carrier structure 102 as a whole, the evaluation unit 118 may be configured for accessing database 128 which may store a plurality of predetermined defect characteristics as a basis for identifying a defect of a test target 116.

When a sufficiently severe defect has been identified for a sufficiently large number of component carrier structures 102 under test, this may be an indication for a substantial problem or issue in a manufacturing plant. In order to tackle such a problem or issue in an attempt to increase yield of the manufacturing process, a manufacturing control unit 250 of the apparatus 100 may be configured for controlling the manufacturing process of manufacturing component carriers based on an output of the evaluation unit 118. More specifically, the manufacturing process may be adjusted or changed based on a result of the evaluating.

As shown as well in Figure 4, apparatus 100 may comprise an interface unit 252 configured for enabling a human intervention, for instance when a result of the evaluation is that further analysis or human intervention is required. Interface unit 252 may be a user interface which functions as an input/output unit and may for instance be a graphical user interface (GUI). Interface unit 252 may comprise input elements (such as a keypad, a computer mouse, a touchscreen and/or a voice recognition system) and output elements (such as a display, a loudspeaker, a touchscreen, etc.). A user may input or select via interface unit 252 input data to be supplied to the apparatus 100. A user input may for instance take a decision about quality when the apparatus 100 does not come to a clear conclusion. Such a user input may be introduced into database 128 and may be used as training data for training the artificial intelligence module 134. Such data is highly appropriate as training data, since it may specifically address weak points of the automated apparatus 100, i.e. scenarios in which the automated apparatus 100 has failed. Thus, taking this measure may continuously improve the performance of the apparatus 100 in terms of defects evaluation. In an embodiment, user intervention is the absolute exception and may occur preferably in less than 5% of the cases.

Apart from this and more generally, the apparatus 100 may be configured for testing quality of a component carrier structure 102 without human intervention. As a result, a highly accurate quality test may be carried out with a high throughput. Correspondingly, the functionality in particular of units 114, 118, 134 and 250 may be carried out by one or multiple processors 260 (which may also correspond to processor 156 shown in Figure 2).

It should be noted that the term "comprising" does not exclude other elements or steps.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention, whose scope is defined by the appended claims.

## Claims

1. Apparatus (100) for testing quality of a component carrier structure (102), wherein the apparatus (100) comprises:
a material removal unit (112) configured for removing material of the component carrier structure (102) for exposing a plane in an interior of the component carrier structure (102);
**characterised in that** the apparatus further comprises:
a detection unit (162) configured for detecting component carrier structure specific data, in particular image data, of the exposed plane of the component carrier structure (102);
a determining unit (114) configured for determining at least one pre-defined test target (116) of the component carrier structure (102) at the exposed plane based on the component carrier structure specific data; and
an evaluation unit (118) configured for identifying and evaluating at least one defect of the at least one determined test target (116) for assessing quality of the component carrier structure (102).

2. The apparatus (100) according to claim 1, wherein the evaluation unit (118) is configured for analyzing a cause for the at least one defect.

3. The apparatus (100) according to claim 1 or 2, wherein the evaluation unit (118) is configured for assessing the quality, and in particular for analyzing a cause for the at least one defect, by an artificial intelligence module (134).

4. The apparatus (100) according to claim 3, wherein the artificial intelligence module (134) comprises at least one of the group consisting of a deep learning tool, a machine learning tool, an expert knowledge tool, and a neural network.

5. The apparatus (100) according to claim 3 or 4, wherein the artificial intelligence module (134) is configured for evaluating the quality by accessing a database (128) comprising empirical data, in particular at least one of cross-sectional images, and a failure catalogue.

6. The apparatus (100) according to any of claims 1 to 5, wherein the evaluation unit (118) is configured for assessing the quality in terms of compliance with at least one user-defined compliance condition.

7. The apparatus (100) according to any of claims 1 to 6, wherein the evaluation unit (118) is configured for assessing the quality in terms of compliance with at least one industrial standard, in particular at least one of IPC-6012 and IPC-A-600.

8. The apparatus (100) according to any of claims 1 to 7, wherein the evaluation unit (118) is configured for evaluating the quality by classifying each of the at least one determined defect in one of at least two classes of defect severity, in particular comprising a first class of quality-critical defects and a second class of quality-uncritical defects, wherein in particular a defect relating to a structural deviation below a predefined threshold value and relating to an electrically insulating layer structure (132) of the component carrier structure (102) is classified as a quality-uncritical defect.

9. The apparatus (100) according to claim 8, wherein each of the following defects is classified as a quality-critical defect:
a defect relating to a structural deviation above a predefined threshold value and relating to an electrically insulating layer structure (132) of the component carrier structure (102);
a defect relating to an electrically conductive layer structure (130) of the component carrier structure (102).

10. The apparatus (100) according to any of claims 1 to 9, comprising at least one of the following features:
wherein the evaluation unit (118) is configured for assessing the quality by classifying the component carrier structure (102) into one of a plurality of pre-defined quality classes, in particular in one quality class of a group of quality classes consisting of "pass", "fail", and "further analysis required";
wherein the evaluation unit (118) is configured for accessing a database (128) storing a plurality of predetermined defect characteristics as a basis for identifying a defect of a test target (116);
wherein the determining unit (114) is configured for determining the at least one test target (116) by automatic image recognition;
wherein the material removal unit (112) is configured for removing material of the component carrier structure (102) by grinding, wherein in particular the material removal unit (112) is configured for removing material of the component carrier structure (102) by one of the group consisting of cross-sectional grinding and flat grinding;
comprising a polishing unit (140) for polishing an exposed plane of the component carrier structure (102) after removing material.

11. The apparatus (100) according to any of claims 1 to 10, comprising at least one of the following features:
wherein the at least one test target (116) of the component carrier structure (102) comprises at least one of the group consisting of at least one drill hole (158), and at least one layer structure (130, 132);
wherein a defect of the at least one test target (116) of the component carrier structure (102) to be evaluated during the quality test comprises at least one of the group consisting of a diameter (D) of a drill hole (158) outside of a range of acceptable values, a distance (L) between adjacent drill holes (158) outside of a range of acceptable values, a width of an electrically conductive trace of an electrically conductive layer structure (130) outside of a range of acceptable values, a distance between adjacent electrically conductive traces of an electrically conductive layer structure (130) outside of a range of acceptable values, a thickness (d) of a layer structure (130, 132) outside of a range of acceptable values, a non-planarity of a layer structure (130, 132), delamination of a layer structure (130, 132), and any deviation of a feature of a printed circuit board-type component carrier structure (102) from a pre-defined specification;
comprising a manufacturing control unit (250) configured for controlling a manufacturing process of manufacturing component carriers and configured for adjusting said manufacturing process based on a result of the evaluating;
comprising a user interface unit (252) configured for enabling a human intervention, in particular when a result of the evaluation is that further analysis or human intervention is required;
wherein the apparatus (100) is configured for testing quality of a component carrier structure (102) without human intervention.

12. A method of testing quality of a component carrier structure (102), wherein the method comprises:
removing material of the component carrier structure (102) for exposing a plane in an interior of the component carrier structure (102);
**characterised in that** the method further comprises:
detecting component carrier structure specific data, in particular image data, of the exposed plane of the component carrier structure (102);
determining at least one pre-defined test target (116) of the component carrier structure (102) at the exposed plane based on the component carrier structure specific data; and
identifying and evaluating at least one defect of the at least one determined test target (116) for assessing quality of the component carrier structure (102).

13. The method according to claim 12, comprising at least one of the following features:
wherein the component carrier structure (102) comprises one of the group consisting of a panel comprising multiple connected preforms of component carriers, an array comprising multiple connected preforms of component carriers, a preform of a component carrier, a coupon, and a component carrier, in particular one of a printed circuit board and an integrated circuit substrate;
wherein the method comprises testing quality of the component carrier structure (102) without human intervention.

14. A computer-readable medium, in which a computer program of testing quality of a component carrier structure (102) is stored, which computer program, when being executed by one or a plurality of processors (260), is adapted to cause an apparatus according to any of claims 1 to 11 to execute the steps of a method according to any of claims 12 or 13.

15. A program element of testing quality of a component carrier structure (102), which program element, when being executed by one or a plurality of processors (260), is adapted to cause an apparatus according to any of claims 1 to 11 to execute the steps of a method according to any of claims 12 or 13.

## Patentansprüche

1. Vorrichtung (100) zum Testen der Qualität einer Komponententrägerstruktur (102), wobei die Vorrichtung (100) aufweist:
eine Materialentfernungseinheit (112), welche konfiguriert ist zum Entfernen von Material der Komponententrägerstruktur (102) zum Freilegen einer Ebene in einem Inneren der Komponententrägerstruktur (102);
**dadurch gekennzeichnet, dass** die Vorrichtung ferner aufweist:
eine Detektionseinheit (162), welche konfiguriert ist zum Detektieren von komponententrägerstrukturspezifischen Daten, insbesondere Bilddaten, der freiliegenden Ebene der Komponententrägerstruktur (102);
eine Bestimmungseinheit (114), welche konfiguriert ist zum Bestimmen mindestens eines vordefinierten Testziels (116) der Komponententrägerstruktur (102) bei der freiliegenden Ebene, basierend auf den komponententrägerstrukturspezifischen Daten; und
eine Evaluationseinheit (118), welche konfiguriert ist zum Identifizieren und Evaluieren mindestens eines Defekts des mindestens einen bestimmten Testziels (116) zum Bewerten der Qualität der Komponententrägerstruktur (102).

2. Die Vorrichtung (100) gemäß Anspruch 1, wobei die Evaluationseinheit (118) konfiguriert ist zum Analysieren eine Ursache für den mindestens einen Defekt.

3. Die Vorrichtung (100) gemäß Anspruch 1 oder 2, wobei die Evaluationseinheit (118) konfiguriert ist zum Bewerten der Qualität und insbesondere zum Analysieren einer Ursache des mindestens einen Defekts mittels eines Künstliche Intelligenz Moduls (134).

4. Die Vorrichtung (100) gemäß Anspruch 3, wobei das Künstliche Intelligenz Modul (134) mindestens eines aus der Gruppe aufweist, bestehend aus einem Deep Learning Tool, einem Maschinenlernen Tool, einem Expertenwissen Tool, und einem neuronalen Netzwerk.

5. Die Vorrichtung (100) gemäß Anspruch 3 oder 4, wobei das Künstliche Intelligenz Modul (134) konfiguriert ist zum Evaluieren der Qualität mittels Zugreifens auf eine Datenbank (128) aufweisend empirische Daten, insbesondere mindestens eines von Querschnittsbildern und einem Fehlerkatalog.

6. Die Vorrichtung (100) gemäß einem beliebigen der Ansprüche 1 bis 5, wobei die Evaluationseinheit (118) konfiguriert ist zum Bewerten der Qualität in Bezug auf das Erfüllen mindestens einer benutzerdefinierten Erfüllungsbedingung.

7. Die Vorrichtung (100) gemäß einem beliebigen der Ansprüche 1 bis 6, wobei die Evaluationseinheit (118) konfiguriert ist zum Bewerten der Qualität in Bezug auf das Erfüllen mindestens eines industriellen Standards, insbesondere mindestens eines von IPC-6012 und IPC-A-600.

8. Die Vorrichtung (100) gemäß einem beliebigen der Ansprüche 1 bis 7, wobei die Evaluationseinheit (118) konfiguriert ist zum Evaluieren der Qualität mittels Klassifizierens jedes des mindestens einen bestimmten Defekts in eine von mindestens zwei Klassen von Defektschwere, insbesondere aufweisend eine erste Klasse von qualitätskritischen Defekten und eine zweite Klasse von qualitätsunkritischen Defekten, wobei insbesondere ein Defekt, welcher eine strukturelle Abweichung unter einem vordefinierten Schwellenwert betrifft, und eine elektrisch isolierende Schichtstruktur (132) der Komponententrägerstruktur (102) betrifft, als ein qualitätsunkritischer Defekt klassifiziert wird.

9. Die Vorrichtung (100) gemäß Anspruch 8, wobei jeder der folgenden Defekte als ein qualitätskritischer Defekt klassifiziert wird:
ein Defekt, welcher eine strukturelle Abweichung über einem vordefinierten Schwellenwert betrifft und eine elektrisch isolierende Schichtstruktur (132) der Komponententrägerstruktur (102) betrifft;
ein Defekt, welcher eine elektrisch leitfähige Schichtstruktur (130) der Komponententrägerstruktur (102) betrifft.

10. Die Vorrichtung (100) gemäß einem beliebigen der Ansprüche 1 bis 9, aufweisend mindestens eines der folgenden Merkmale:
wobei die Evaluationseinheit (118) konfiguriert ist zum Bewerten der Qualität mittels Klassifizierens der Komponententrägerstruktur (102) in eine von einer Mehrzahl von vordefinierten Qualitätsklassen, insbesondere in eine Qualitätsklasse aus einer Gruppe von Qualitätsklassen, bestehend aus "bestanden", "durchgefallen", und "weitere Analyse erforderlich";
wobei die Evaluationseinheit (118) konfiguriert ist zum Zugreifen auf eine Datenbank (128), welche eine Mehrzahl von vordefinierten Defektcharakteristika als eine Basis zum Identifizieren eines Defekts eines Testziels (116) speichert;
wobei die Bestimmungseinheit (114) konfiguriert ist zum Bestimmen des mindestens einen Testziels (116) mittels automatischer Bilderkennung;
wobei die Materialentfernungseinheit (112) konfiguriert ist zum Entfernen von Material der Komponententrägerstruktur (102) mittels Schleifens, wobei insbesondere die Materialentfernungseinheit (112) konfiguriert ist zum Entfernen von Material der Komponententrägerstruktur (102) mittels einem aus der Gruppe, bestehend aus Querschnittsschleifen und flachem Schleifen;
aufweisend eine Poliereinheit (140) zum Polieren einer freiliegenden Ebene der Komponententrägerstruktur (102) nach dem Entfernen des Materials.

11. Die Vorrichtung (100) gemäß einem beliebigen der Ansprüche 1 bis 10, aufweisend mindestens eines der folgenden Merkmale:
wobei das mindestens eine Testziel (116) der Komponententrägerstruktur (102) mindestens eines aus der Gruppe aufweist, bestehend aus mindestens einem Bohrloch (158) und mindestens einer Schichtstruktur (130, 132);
wobei ein Defekt des mindestens einen Testziels (116) der Komponententrägerstruktur (102), welche während des Qualitätstests zu evaluieren ist, mindestens eines aus der Gruppe aufweist, bestehend aus einem Durchmesser (D) eines Bohrlochs (158) außerhalb eines Bereichs von akzeptablen Werten, einem Abstand (L) zwischen benachbarten Bohrlöchern (158) außerhalb eines Bereichs von akzeptablen Werten, einer Breite einer elektrisch leitfähigen Bahn einer elektrisch leitfähigen Schichtstruktur (130) außerhalb eines Bereichs von akzeptablen Werten, einem Abstand zwischen benachbarten elektrisch leitfähigen Bahnen einer elektrisch leitfähigen Schichtstruktur (130) außerhalb eines Bereichs von akzeptablen Werten, einer Dicke (d) einer Schichtstruktur (130, 132) außerhalb eines Bereichs von akzeptablen Werten, einer Nicht-Planarität einer Schichtstruktur (130, 132), einer Delaminierung einer Schichtstruktur (130, 132), und einer beliebigen Abweichung eines Merkmals einer gedruckte-Leiterplatte-artigen Komponententrägerstruktur (102) von einer vordefinierten Spezifizierung;
aufweisend eine Herstellungssteuereinheit (250), welche konfiguriert ist zum Steuern eines Herstellungsprozesses zum Herstellen von Komponententrägern, und welche konfiguriert ist zum Einstellen des Herstellungsprozesses basierend auf einem Ergebnis der Evaluation;
aufweisend eine Benutzerschnittstelleneinheit (252), welche konfiguriert ist zum Ermöglichen eines menschlichen Eingreifens, insbesondere wenn ein Ergebnis der Evaluation ist, dass eine weitere Analyse oder ein menschliches Eingreifen erforderlich ist;
wobei die Vorrichtung (100) konfiguriert ist zum Testen der Qualität einer Komponententrägerstruktur (102) ohne ein menschliches Eingreifen.

12. Ein Verfahren zum Testen der Qualität einer Komponententrägerstruktur (102), wobei das Verfahren aufweist:
Entfernen von Material der Komponententrägerstruktur (102) zum Freilegen einer Ebene in einem Inneren der Komponententrägerstruktur (102);
**dadurch gekennzeichnet, dass** das Verfahren ferner aufweist:
Detektieren von komponententrägerstrukturspezifischen Daten, insbesondere Bilddaten, der freiliegenden Ebene der Komponententrägerstruktur (102);
Bestimmen mindestens eines vordefinierten Testziels (116) der Komponententrägerstruktur (102) bei der freiliegenden Ebene, basierend auf den komponententrägerstrukturspezifischen Daten; und
Identifizieren und Evaluieren mindestens eines Defekts des mindestens einen bestimmten Testziels (116) zum Bewerten der Qualität der Komponententrägerstruktur (102).

13. Das Verfahren gemäß Anspruch 12, aufweisend mindestens eines der folgenden Merkmale:
wobei die Komponententrägerstruktur (102) eines aus der Gruppe aufweist, bestehend aus einem Panel aufweisend mehrere verbundene Vorformen von Komponententrägern, einem Array aufweisend mehrere verbundene Vorformen von Komponententrägern, einer Vorform eines Komponententrägers, einem Coupon, und einem Komponententräger, insbesondere eines von einer gedruckten Leiterplatte und einem integrierten Schaltkreissubstrat;
wobei das Verfahren aufweist
Testen der Qualität der Komponententrägerstruktur (102) ohne menschliches Eingreifen.

14. Ein computerlesbares Medium, in welchem ein Computerprogramm zum Testen der Qualität einer Komponententrägerstruktur (102) gespeichert ist, welches Computerprogramm, wenn es mittels eines oder einer Mehrzahl von Prozessoren (260) ausgeführt wird, eingerichtet ist, eine Vorrichtung gemäß einem beliebigen der Ansprüche 1 bis 11 zu veranlassen, die Schritte eines Verfahrens gemäß einem beliebigen der Ansprüche 12 oder 13 auszuführen.

15. Ein Programmelement zum Testen der Qualität einer Komponententrägerstruktur (102), welches Programmelement, wenn es mittels eines oder einer Mehrzahl von Prozessoren (260) ausgeführt wird, eingerichtet ist, eine Vorrichtung gemäß einem beliebigen der Ansprüche 1 bis 11 zu veranlassen, die Schritte eines Verfahrens gemäß einem beliebigen der Ansprüche 12 oder 13 auszuführen.

## Revendications

1. Appareil (100) pour tester la qualité d'une structure de support de composant (102), dans lequel l'appareil (100) comprend :
une unité de retrait de matériau (112) configurée pour retirer du matériau à partir de la structure de support de composant (102) afin d'exposer un plan dans un intérieur de la structure de support de composant (102) ;
**caractérisé en ce que** le procédé comprend en outre :
une unité de détection (162) configurée pour détecter des données spécifiques de structure de support de composant, en particulier des données d'image, du plan exposé de la structure de support de composant (102) ;
une unité de détermination (114) configurée pour déterminer au moins une cible de test prédéfinie (116) de la structure de support de composant (102) au niveau du plan exposé sur la base des données spécifiques de structure de support de composant ; et
une unité d'évaluation (118) configurée pour identifier et évaluer au moins un défaut de la au moins une cible de test déterminée (116) afin d'évaluer la qualité de la structure de support de composant (102).

2. Appareil (100) selon la revendication 1, dans lequel l'unité d'évaluation (118) est configurée pour analyser une cause pour le au moins un défaut.

3. Appareil (100) selon la revendication 1 ou 2, dans lequel l'unité d'évaluation (118) est configurée pour évaluer la qualité, et en particulier pour analyser une cause du au moins un défaut, par un module d'intelligence artificielle (134).

4. Appareil (100) selon la revendication 3, dans lequel le module d'intelligence artificielle (134) comprend au moins l'un du groupe constitué d'un outil d'apprentissage profond, d'un outil d'apprentissage automatique, d'un outil de connaissance expert et d'un réseau neuronal.

5. Appareil (100) selon la revendication 3 ou 4, dans lequel le module d'intelligence artificielle (134) est configuré pour évaluer la qualité en accédant à une base de données (128) comprenant des données empiriques, en particulier au moins une parmi des images de section transversale, et un catalogue de défaillances.

6. Appareil (100) selon l'une quelconque des revendications 1 à 5, dans lequel l'unité d'évaluation (118) est configurée pour évaluer la qualité en termes de conformité à au moins une condition de conformité définie par un utilisateur.

7. Appareil (100) selon l'une quelconque des revendications 1 à 6, dans lequel l'unité d'évaluation (118) est configurée pour évaluer la qualité en termes de conformité à au moins une norme industrielle, en particulier au moins l'une des normes IPC-6012 et IPC-A-600.

8. Appareil (100) selon l'une quelconque des revendications 1 à 7, dans lequel l'unité d'évaluation (118) est configurée pour évaluer la qualité en classant chaque au moins un défaut déterminé dans l'une d'au moins deux classes de gravité de défaut, comprenant en particulier une première classe de défauts critiques pour la qualité et une seconde classe de défauts non critiques pour la qualité, dans lequel en particulier un défaut relatif à un écart structurel en dessous d'une valeur de seuil prédéfinie et relatif à une structure de couche électriquement isolante (132) de la structure de support de composant (102) est classé comme un défaut non critique pour la qualité.

9. Appareil (100) selon la revendication 8, dans lequel chacun des défauts suivants est classé comme un défaut critique pour la qualité :
un défaut relatif à une déviation structurelle au-dessus d'une valeur de seuil prédéfinie et relatif à une structure de couche électriquement isolante (132) de la structure de support de composant (102) ;
un défaut relatif à une structure de couche électriquement conductrice (130) de la structure de support de composant (102).

10. Appareil (100) selon l'une quelconque des revendications 1 à 9, comprenant au moins l'une des caractéristiques suivantes :
dans lequel l'unité d'évaluation (118) est configurée pour évaluer la qualité en classant la structure de support de composant (102) dans l'une d'une pluralité de classes de qualité prédéfinies, en particulier dans une classe de qualité d'un groupe de classes de qualité consistant en « réussite », « échec » et « analyse supplémentaire requise » ;
dans lequel l'unité d'évaluation (118) est configurée pour accéder à une base de données (128) stockant une pluralité de caractéristiques de défaut prédéterminées en tant que base pour identifier un défaut d'une cible de test (116) ;
dans lequel l'unité de détermination (114) est configurée pour déterminer la au moins une cible de test (116) par reconnaissance d'image automatique ;
dans lequel l'unité de retrait de matériau (112) est configurée pour retirer du matériau à partir de la structure de support de composant (102) par meulage, dans lequel en particulier l'unité de retrait de matériau (112) est configurée pour retirer du matériau à partir de la structure de support de composant (102) par l'un du groupe constitué du meulage en section transversale et du meulage à plat ;
comprenant une unité de polissage (140) pour polir un plan exposé de la structure de support de composant (102) après avoir retiré du matériau.

11. Appareil (100) selon l'une quelconque des revendications 1 à 10, comprenant au moins l'une des caractéristiques suivantes :
dans lequel la au moins une cible de test (116) de la structure de support de composant (102) comprend au moins l'un du groupe constitué d'au moins un trou de perçage (158), et d'au moins une structure de couche (130, 132) ;
dans lequel un défaut de la au moins une cible de test (116) de la structure de support de composant (102) à évaluer pendant le test de qualité comprend au moins l'un du groupe constitué d'un diamètre (D) d'un trou perçage (158) en dehors d'une plage de valeurs acceptables, d'une distance (L) entre des trous de forage adjacents (158) en dehors d'une plage de valeurs acceptables, d'une largeur d'une trace électroconductrice d'une structure de couche électroconductrice (130) en dehors d'une plage de valeurs acceptables, d'une distance entre des traces électroconductrices adjacentes d'une structure de couche électroconductrice (130) en dehors d'une plage de valeurs acceptables, d'une épaisseur (d) d'une structure de couche (130, 132) en dehors d'une plage de valeurs acceptables, d'une non planéité d'une structure de couche (130, 132), d'un délaminage d'une structure de couche (130, 132) et de toute déviation d'une caractéristique d'une structure de support de composant de type carte de circuit imprimé (102) par rapport à une spécification prédéfinie ;
comprenant une unité de commande de fabrication (250) configurée pour commander un processus de fabrication consistant à fabriquer des supports de composant et configurée pour ajuster ledit processus de fabrication sur la base d'un résultat de l'évaluation ;
comprenant une unité d'interface utilisateur (252) configurée pour permettre une intervention humaine, en particulier lorsqu'un résultat de l'évaluation indique qu'une analyse ou une intervention humaine supplémentaire est nécessaire ;
dans lequel l'appareil (100) est configuré pour tester la qualité d'une structure de support de composant (102) sans intervention humaine.

12. Procédé de test de la qualité d'une structure de support de composant (102),
dans lequel le procédé comprend les étapes consistant à :
retirer un matériau de la structure de support de composant (102) afin d'exposer un plan à l'intérieur de la structure de support de composant (102) ;
**caractérisé en ce que** le procédé comprend en outre les étapes consistant à
détecter des données spécifiques de structure de support de composant, en particulier des données d'image, du plan exposé de la structure de support de composant (102) ;
déterminer au moins une cible de test prédéfinie (116) de la structure de support de composant (102) au niveau du plan exposé sur la base des données spécifiques de structure de support de composant ; et
identifier et évaluer au moins un défaut de la au moins une cible de test déterminée (116) pour évaluer la qualité de la structure de support de composant (102).

13. Procédé selon la revendication 12, comprenant au moins l'une des caractéristiques suivantes :
dans lequel la structure de support de composant (102) comprend l'un du groupe constitué d'un panneau comprenant de multiples préformes connectées de supports de composant, d'un réseau comprenant de multiples préformes connectées de supports de composant, d'une préforme d'un support de composant, d'un coupon et d'un support de composant, en particulier l'un d'une carte de circuit imprimé et d'un substrat de circuit intégré ;
dans lequel le procédé comprend le test de la qualité de la structure de support de composant (102) sans intervention humaine.

14. Support lisible par ordinateur, dans lequel est stocké un programme informatique de test de qualité d'une structure de support de composant (102), lequel programme informatique, lorsqu'il est exécuté par un ou une pluralité de processeurs (260), est adapté pour amener un appareil selon l'une quelconque des revendications 1 à 11 à exécuter les étapes d'un procédé selon l'une quelconque des revendications 12 ou 13.

15. Élément de programme de test de qualité d'une structure de support de composant (102), lequel élément de programme, lorsqu'il est exécuté par un ou une pluralité de processeurs (260), est adapté pour amener un appareil selon l'une quelconque des revendications 1 à 11 à exécuter les étapes d'un procédé selon l'une quelconque des revendications 12 ou 13.
